Europäisches Patentamt

European Patent Office

Office européen des brevets

(19)

(11) Numéro de publication: **0 265 320 B1**

(12) **FASCICULE DE BREVET EUROPEEN**

(45) Date de publication de fascicule du brevet:
04.09.91

(51) Int. Cl.⁵: **C23C 14/00, C23C 14/34**

(21) Numéro de dépôt: 87402242.9

(22) Date de dépôt: 08.10.87

(54) Dispositif de dépôt sous vide par pulvérisation cathodique réactive sur une feuille de verre.

(30) Priorité: 11.10.86 DE 3634710

(43) Date de publication de la demande:
27.04.88 Bulletin 88/17

(45) Mention de la délivrance du brevet:
04.09.91 Bulletin 91/36

(84) Etats contractants désignés:
AT BE CH DE ES FR GB IT LI LU NL SE

(56) Documents cités:
US-A- 4 094 763

PATENT ABSTRACTS OF JAPAN, vol. 9, no.
91 (C-277)[1814], 19 avril 1985; & JP-A-59 222
575 (TEIJIN K.K.) 14-12-1984

PATENT ABSTRACTS OF JAPAN, vol. 6, no.
73 (C-101)[951], 8 mai 1982; & JP-A-57 9872
(OKI DENKI KOGYO K.K.) 19-01-1982

(73) Titulaire: **SAINT-GOBAIN VITRAGE INTERNA-TIONAL**
**18, avenue d'Alsace**
**F-92400 Courbevoie(FR)**

(84) Etats contractants désignés:
**BE CH ES FR GB IT LI LU NL SE AT**

Titulaire: **VEGLA Vereinigte Glaswerke GmbH**
**Viktoriaallee 3-5**
**W-5100 Aachen(DE)**

(84) Etats contractants désignés:
**AT BE CH DE ES FR GB IT LI LU NL SE**

(72) Inventeur: **Heitzer, Xaver**
**Alfred-Nobel Strasse 21**
**W-5000 Köln 90(DE)**

(74) Mandataire: **de Toytot, Robert et al**
**SAINT-GOBAIN RECHERCHE 39 quai Lucien**
**Lefranc B.P. 135**
**F-93304 Aubervilliers Cédex(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

L'invention concerne un dispositif pour déposer sous vide, notamment par pulvérisation cathodique réactive, sur un substrat transparent en feuille disposé en position horizontale, une couche non métallique constituée d'un semi-conducteur, d'oxyde métallique ou d'un autre composé métallique, comportant une chambre de dépôt dans laquelle le vide peut être établi, un dispositif de support ou de transport pour le substrat à revêtir, au moins une cathode disposée au-dessus du substrat et portant le matériau de revêtement, et des électrodes et/ou des tôles de protection et/ou des diaphragmes disposés à l'intérieur de la chambre de dépôt.

Des dispositifs de ce type trouvent en particulier une application pour le revêtement de feuilles de verre ou de matière plastique par des couches électriquement conductrices et/ou réfléchissant la chaleur. En général, pour obtenir une couche réfléchissant la chaleur et/ou électriquement conductrice, on dispose une couche métallique, par exemple d'or, d'argent et/ou de cuivre, comprise entre des couches d'ancrage et/ou des couches de protection disposées respectivement audessous et au-dessus de cette couche métallique. Les couches d'ancrage et/ou les couches de protection peuvent comporter, par exemple, un oxy-de métallique ou un sulfure métallique. Un empilement de couches qui a fourni de bons résultats pour le revêtement de feuilles de verre de silicate est constitué par exemple d'une couche de bioxyde d'étain formant couche d'ancrage, d'une couche d'argent formant couche réfléchissante, d'une couche mince de protection en un oxyde métallique et d'une couche anti-reflets en bioxyde d'étain.

Les dispositifs de dépôt sous vide du type mentionné ci-dessus travaillent d'une manière particulièrement économique lorsqu'ils fonctionnent selon le principe de la pulvérisation cathodique réactive assistée par un champ magnétique. Pour le dépôt de couches d'oxydes métalliques, selon cette technique, dite aussi pulvérisation cathodique réactive à magnétron, on utilise des cibles métalliques comme cathodes, et le métal pulvérisé est oxydé, lors du processus réactif, au moyen d'oxygène ajouté en faibles proportions au gaz introduit dans la chambre de dépôt, formant ainsi sur le substrat la couche désirée d'oxyde métallique.

Les dispositifs de dépôt sous vide fonctionnant, selon le principe de la pulvérisation cathodique sont en général munis d'accessoires supplémentaires insérés entre la cathode et le substrat à revêtir. Ces accessoires supplémentaires ont des rôles différents. Ainsi le rôle des électrodes désignées sous le terme d'anodes, qui sont disposées symétriquement par rapport aux cathodes et à proximité de ces dernières, consiste à disperser et stabiliser le nuage de plasma. A cet effet, on applique à ces anodes un potentiel électrique positif par rapport au potentiel électrique de la cathode et par rapport au potentiel du boîtier métallique de la chambre à vide. Les anodes de l'art connu présentent la forme de profilés circulaires ou de tubes. Outre les anodes et éventuellement aussi à la place de ces dernières, on peut également disposer au-dessus du substrat des tôles de protection ou des diaphragmes. Le rôle de ces diaphragmes consiste en premier lieu à limiter le flux des particules parvenant jusqu'à la surface supérieure du substrat au rayonnement principal des particules pulvérisées, de haute énergie, éliminant ainsi les composantes latérales du faisceau de particules, de vitesse nettement plus faible. De même, on peut imposer à ces tôles de protection ou à ces diaphragmes un potentiel électrique qui peut être égal par exemple au potentiel de masse du boîtier de la chambre de dépôt, ou bien être éventuellement un potentiel positif par rapport à ce potentiel. En outre, de telles installations peuvent également comporter des tôles de protection disposées au-dessous du plan de la feuille de verre, par exemple latéralement, à côté du substrat à revêtir, afin que ces tôles protègent les parties de l'installation situées au-dessous, contre un dépôt du matériau pulvérisé.

Sur les surfaces et parties des électrodes, des diaphragmes et des autres tôles de protection, ainsi que sur d'autres surfaces regardant la cathode de composants de construction de la chambre à vide, il se forme pendant le fonctionnement de l'installation des dépôts de matériau pulvérisé dont l'épaisseur augmente avec le temps. Il apparaît des contraintes mécaniques intenses dans les couches de ces dépôts ou entre ces couches et le support métallique. Ces contraintes mécaniques peuvent prendre des valeurs particulièrement élevées dans le cas de variations de températures, telles que celles auxquelles une telle installation de dépôt est soumise, en particulier, à l'occasion de son démarrage ou lors de son arrêt, en raison des coefficients de dilatation thermique très différents des composants métalliques et des dépôts non métalliques. Lorsqu'ainsi les couches déposées sont constituées par un matériau non ductile, c'est-à-dire cassant, les contraintes ne peuvent pas être éliminées par déformation plastique. Avec l'épaisseur du dépôt, les contraintes mécaniques s'accroissent, lorsque la durée de fonctionnement augmente, et la limite de résistance mécanique des couches déposées peut se trouver dépassée. Ainsi, sous l'action de ces contraintes, des fragments des couches déposées peuvent se détacher alors du support et tomber, ou sauter, à travers l'ouverture des diaphragmes et échouer à la surface du substrat. De ce fait, il apparaît des défauts dans le revêtement formé sur le substrat. Afin d'éviter de tels défauts, il faut interrompre le processus de dépôt à intervalles réguliers afin d'éliminer les dépôts sur les composants concernés par de telles couches de dépôts fragiles ou bien remplacer les composants portant de tels dépôts par des composants ayant subi un nettoyage. Ces interruptions nécessaires entraînent une perturbation très prejudiciable à la productivité et à la rentabilité d'une telle installation de dépôt.

L'invention a pour but de réduire ou de préférence éliminer les défauts dûs au décollement de dépôts du matériau de revêtement sur les électrodes, diaphragmes, tôles de protection ou autres composants susceptibles d'être placés à l'intérieur de la chambre de dépôt des installations de pulvérisation sous vide, et d'allonger les périodes de fonctionnement continu de telles installations, améliorant ainsi leur rentabilité.

Conformément à l'invention, ces objectifs se trouvent atteints si les éléments ou surfaces, susceptibles d'être exposés au flux de particules émis par la cathode, des électrodes et/ou d'autres composants du dispositif situés à l'intérieur de la chambre de dépôt sont pourvus de rives et/ou de parties saillants, en forme d'arête tranchante, c'est-à-dire comportant des surfaces formant entre elles un angle aigü, lesdits éléments n'exposant au-dit flux, à proximité des rives regardant le substrat à revêtir, aucune surface inclinée vers le bas en direction desdites rives.

Les dispositions conformes à l'invention permettent d'aboutir de façon étonnante à ce que le risque de décollement ou d'éjection de fragments des dépôts formés soit fortement réduit. Cet effet résulte manifestement du fait que les contraintes mécaniques, qui apparaissent à l'intérieur du dépôt et/ou entre le dépôt et le support métallique, se trouvent réduites ou même éliminées lorsque les couches de dépôt se fissurent selon une géométrie linéaire le long des arêtes vives ou des parties saillantes de forme tranchante, sans que les couches de dépôt ne perdent par ailleurs leur cohésion. En général, les couches de dépôt se détachent partiellement de leur support lors de la fissuration le long de ces "zones de rupture imposée, mais il se forme des fragments de surface étendue qui adhèrent encore au moins par endroits au support. Les couches de dépôt qui se sont fissurées et se sont soulevées ou détachées partiellement du support se trouvent ensuite retenues en partie grâce aux dépôts ultérieurs.

Selon une forme de réalisation préférée de l'invention, les rives des diaphragmes constitués de plaques se présentent sous la forme d'une lame tranchante effilée, dont la face inférieure, en biseau et sensiblement plane, fait un angle alpha inférieur ou égal à 45 degrés par rapport à la face supérieure. De cette manière, on obtient, outre la création de lignes de rupture imposée dans les couches de dépôt, suivant les arêtes vives, que la face biseautée frontale de ces composants soit tournée sur toute sa largeur à l'opposé de la cathode et du flux de particules, de sorte que la possibilité de formation de couches de dépôt sur cette surface est fortement réduite.

D'autres formes de réalisation avantageuses de l'invention font l'objet des revendications et vont être décrites ci-après de façon plus détaillée en référence aux dessins.

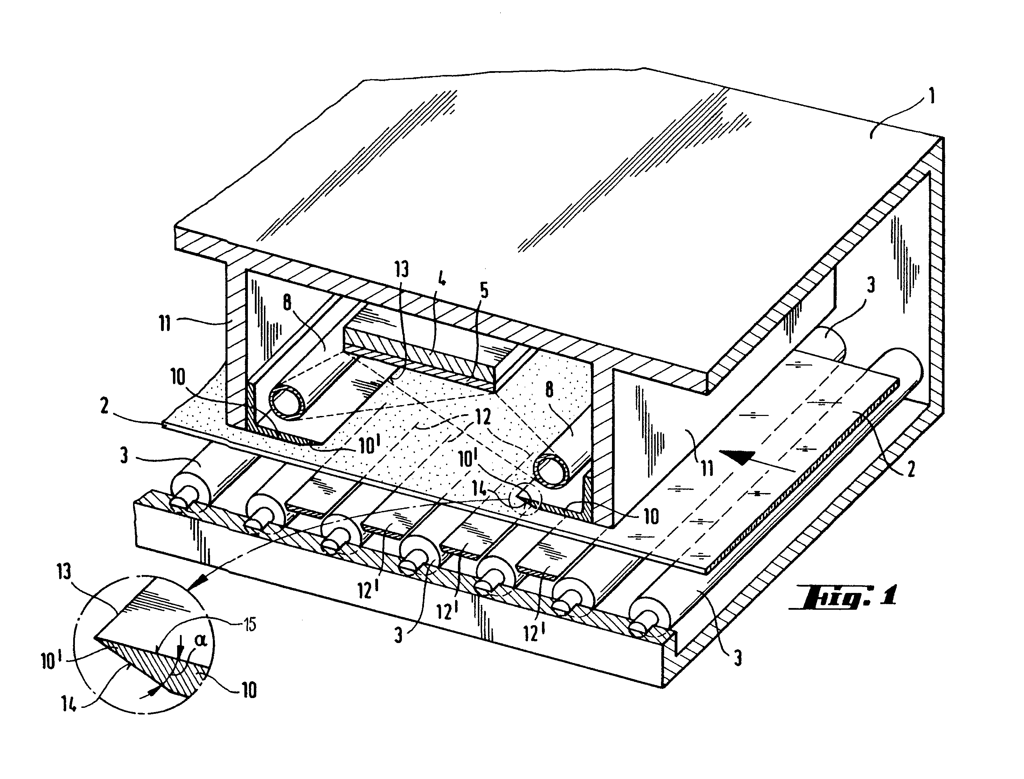

Dans les dessins, la figure 1 représente une chambre de dépôt d'une installation de pulvérisation cathodique fonctionnant en continu et servant à réaliser le revêtement de feuilles de verre, munie de ses composants les plus importants, selon une vue en perspective représentée en coupe partielle.

La figure 2 représente une forme de réalisation modifiée de la rive d'un diaphragme réalisé conformément à l'invention, selon une vue à plus grande échelle.

La figure 3 représente une forme de réalisation possible d'une surface d'un diaphragme, réalisée conformément à l'invention, et

La figure 4 représente une autre forme de réalisation d'une configuration de surface, conforme à l'invention, d'une tôle de protection ou d'un autre composant exposé au flux de particules dans une chambre de dépôt.

Sur la figure 1, on a représenté la structure de base d'une chambre de dépôt à l'intérieur d'une installation de pulvérisation cathodique fonctionnant en continu pour des feuilles de verre, munie de ses éléments constitutifs essentiels. L'installation est constituée par un boîtier en forme de canal étanche au vide 1, d'une structure mécanique stable, à travers lequel les feuilles de verre 2 destinées à recevoir le revêtement sont déplacées sur une voie de transport comportant des rouleaux de transport 3. En avant et en arrière de la chambre de dépôt proprement dite se trouvent ménagées des chambres formant sas, qui servent respectivement à introduire les plaques de verre destinées à recevoir leur revêtement dans l'installation placée sous vide poussé, ou à les en extraire après qu'elles aient été revêtues. La zone de l'installation où s'effectue pratiquement le revêtement comporte plusieurs chambres de dépôt disposées les unes derrière les autres, par exemple quatre chambres de dépôt lorsqu'il est prévu de déposer un empilement de couches comprenant quatre couches. Chaque chambre de dépôt possède la même structure de base.

Dans la chambre de dépôt, une cathode allongée 4, qui s'étend sur toute la largeur de l'installation ou du moins sur la largeur des feuilles de verre destinées à être revêtues, est disposée en regard des rouleaux de transport 3 et parallèlement à ces derniers. Sur la face inférieure de la cathode 4 se trouve fixée la cible 5, qui est constituée du matériau à déposer sur le substrat au moyen de la pulvérisation cathodique. Une tension négative est appliquée à la cathode 4 ou à la cible 5 tandis que le boîtier 1 est placé au potentiel de masse. Grâce à des conduites tubulaires non représentées, de faibles quantités de gaz, par exemple de l'argon, sont introduites dans la chambre de dépôt. Les molécules de gaz sont ionisées dans le champ électrique, et viennent frapper à grande vitesse la surface de la cible 5 dont, sous l'effet des chocs, elles éjectent des atomes métalliques constituant un nuage de plasma sous la forme de particules chargées négativement qui sont accélérées en direction des pièces placées au potentiel de masse ou à un potentiel positif. Ces particules s'accumulent sur la surface du substrat et sur d'autres surfaces soumises à l'action du nuage de plasma, à l'intérieur de la chambre de dépôt.

Dans le cas de la pulvérisation cathodique assistée par un champ magnétique, la vitesse de dépôt est fortement augmentée par la mise en oeuvre d'un champ magnétique intense au-dessous de la cathode, au moyen de forts aimants permanents disposés dans la cathode. Pour une meilleure vue d'ensemble, on n'a pas représenté le dispositif à aimants sur les dessins.

Afin d'accroître la stabilité du nuage de plasma en formation et d'élargir ce nuage de plasma, latéralement et au-dessous de la cathode 4 se trouvent disposés des corps d'anodes tubulaires 8 parallèles et symétriques par rapport à la cathode 4, anodes auxquelles est appliqué un potentiel électrique positif. En outre, des plaques de protection ou des diaphragmes 10 disposés au-dessous de ces corps d'anodes 8 et à une faible distance au-dessus de la feuille de verre 2, sont fixés aux parois verticales 11 délimitant la chambre de dépôt. Ces diaphragmes 10 ont pour rôle de collecter les composantes latérales du flux de particules et de ne laisser passer que le flux principal qui vient frapper la surface du substrat sous une incidence sensiblement perpendiculaire et avec une énergie élevée. Les diaphragmes 10 sont en général placés au potentiel de masse.

Le matériau de revêtement se dépose aussi bien sur les corps d'anodes 8 et les diaphragmes 10 que sur la feuille de verre, et ceci précisément sur la partie de leur surface tournée vers la cathode. De même, le matériau de revêtement se dépose sur les extrémités 12', dans leur partie non protégée par la feuille de verre 2, des plaques de protection 12 disposées entre les rouleaux de transport 3 au-dessous de ladite feuille de verre. Bien que les plaques de protection 12 soient disposées au-dessous du plan de la feuille de verre 2, les dépôts parasites qui se forment en ces endroits peuvent cependant projeter des fragments susceptibles de parvenir sur la surface de la feuille de verre lors de fractures du revêtement sous l'effet des contraintes affectant ces dépôts.

Les diaphragmes 10 sont constitués par des plaques de tôle possédant une épaisseur de quelques millimètres. Les rives, ou chants de ces diaphragmes 10 constituent des zones critiques du point de vue de l'opération de dépôt du matériau de revêtement, du fait du décollement de ces dépôts parasites. Conformément à l'invention, la zone de la rive 10' est effilée en forme de lame tranchante, et l'angle alpha formé par les faces de la rive des diaphragmes doit être égal ou inférieur à 45 degrés. De façon appropriée, le fil du tranchant 13 se situe à un niveau au moins égal à celui du reste de la partie active, exposée aux dépôts parasites, de la face supérieur du corps du diaphragme 10, de sorte que seule la face inférieure dudit corps comporte une partie oblique 14 regardant la feuille de verre à revêtir. On vise ainsi à éviter, sur la face supérieure 15 du diaphragme, toute surface inclinée vers le bas en direction et à proximité du bord du diaphragme, qui faciliterait la chute sur la feuille de verre de fragments du dépôt parasite.

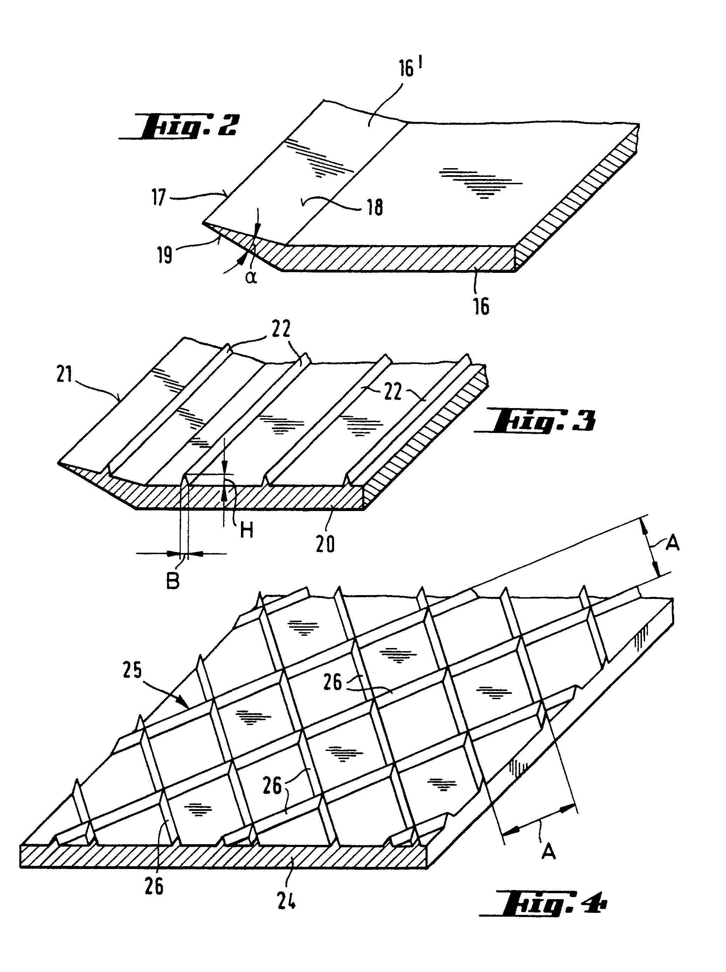

Une forme de réalisation, constituant un perfectionnement jouant dans le sens indiqué en dernier lieu, est représentée sur la figure 2 pour la configuration de la zone de la rive 16' d'un diaphragme 16. Dans ce cas, la rive du diaphragme présente à nouveau un bord au tranchant effilé 17, formé par la face inclinée supérieure 18 et par la face inclinée inférieure 19, ces deux faces inclinées 18, 19 faisant à nouveau un angle alpha égal ou de préférence inférieur à 45 degrés, et ladite face inclinée superieure 18 présentant une pente ascendante en direction du tranchant 17, de sorte que les fragments d'une couche de dépôt éventuellement libérés sur la face inclinée 18 tendent à se déplacer selon la direction opposée, sur la pente de cette face inclinée, et à demeurer sur le corps du diaphragme.

Selon la forme de réalisation représentée sur la figure 3, la surface supérieure du corps du diaphragme 20 comporte plusieurs parties saillantes prismatiques 22, qui s'étendent parallèlement au bord à tranchant effilé 21 et possèdent elles-mêmes des arêtes effilées. Les parties saillantes prismatiques 22 possèdent une hauteur H comprise entre 2 et 10 mm et de préférence comprise entre 4 et 6 mm, et leur surface de base possède une largeur B comprise entre 2 et 4 mm, l'angle formé par les faces des primes au niveau du bord de forme tranchante étant dans tous les cas inférieur à 45 degrés.

Comme cela est représenté sur la figure 4, les surfaces soumises à un risque de dépôt parasite, par exemple la face supérieure d'une tôle de protection 24, peuvent être également munies d'une grille 25 en forme de réseau formé par des corps prismtiques saillants 26 en forme de lames. Les corps prismatiques 26 peuvent posséder les mêmes dimensions en coupe transversale que les corps prismatiques 22 de la figure 3. La distance A entre les corps prismatiques 26 peut varier dans de larges limites ; on obtient de bons résultats lorsque la distance A est comprise entre 5 et 25 mm et de préférence entre 10 et 15 mm.

Il n'est pas nécessaire que les parties saillantes prismatiques 22 ou les grilles 25 en forme de réseaux soient réalisées d'un seul tenant avec leur support respectif. Bien plus, le but recherché est également atteint lorsque les corps prismatiques ou les grilles en forme de réseaux sont réalisés sous la forme d'éléments distincts de leur support respectif. A titre de grilles 25 en forme de réseaux, conviennent ainsi par exemple également des formes de réalisation particulières de panneaux en métal déployé disponibles dans le commerce, qui sont constitués par un réseau maillé rigide qui est obtenu par découpage et étirage ultérieur de feuilles de tôle d'acier.

## Revendications

1. Dispositif pour déposer sous vide, notamment par pulvérisation cathodique réactive, sur un substrat transparent en feuille disposé en position horizontale, une couche non métallique constituée d'un semiconducteur, d'un oxyde métallique ou d'un autre composé métallique comportant une chambre de dépôt dans laquelle le vide peut être établi, un dispositif de support ou de transport pour le substrat à revêtir, au moins une cathode disposée au-dessus du substrat et portant le matériau de revêtement, et des électrodes et/ou des tôles de protection et/ou des diaphragmes disposés à l'intérieur de la chambre de dépôt, caractérisé en ce que les éléments ou surfaces susceptibles d'être exposés au flux de particules émis par la cathode, des électrodes (8) et/ou diaphragmes (10) et/ou tôles de protection (12) et/ou autres composants du dispositif situés à l'intérieur de la chambre de dépôt sont pourvus de rives (10', 16') et/ou de parties saillantes (22, 26) en forme d'arête tranchante, c'est-à-dire comportant des surfaces qui font un angle aigü entre elles, lesdits éléments n'exposant audit flux, à proximité des rives regardant le substrat à revêtir, aucune surface inclinée vers le bas en direction desdites rives.

2. Dispositif selon la revendication 1, caractérisé en ce que les rives (10', 16') des diaphragmes (10, 16) constitués de plaques sont réalisées sous la forme d'une lame tranchante effilée dont la face inférieure, en biseau (14, 19) et sensiblement plane, fait un angle alpha inférieur ou égal à 45 degrés par rapport à la face supérieure (15, 18).

3. Dispositif selon la revendication 2, caractérisé en ce que la rive (16') du diaphragme (16) est repliée vers le haut.

4. Dispositif selon la revendication 1, caractérisé en ce que les parties saillantes de forme tranchante (22, 26) possèdent une hauteur (H) comprise entre 2 et 10 mm.

5. Dispositif selon la revendication 4, caractérisé en ce que les parties saillantes de forme tranchante (22, 26) sont fixées, sous la forme de corps profilés distincts, sur leur support respectif.

6. Dispositif selon la revendication 5, caractérisé en ce que les corps profilés distincts sont constitués de grilles (25) en forme de réseaux.

7. Dispositif selon la revendication 6, caractérisé en ce que les grilles (25) sont constituées de panneaux de métal déployé.

## Claims

1. Apparatus for vacuum deposition, particularly by reactive cathodic sputtering, on a horizontally positioned, transparent sheet substrate of a nonmetallic layer constituted by a semiconductor, a metal oxide or some other metal compound, which has a deposition chamber in which the vacuum can be established, a supporting or conveying device for the substrate to be coated, at least one cathode positioned above the substrate and carrying the coating material, and electrodes and/or protective metal sheets and/or diaphragms positioned within the deposition chamber, characterized in that the elements or surfaces exposable to the flow of particles emitted by the cathode, electrodes (8) and/or diaphragms (10) and/or protective metal sheets (12) and/or other components of the apparatus located within the deposition chamber are provided with edges (10', 16') and/or projecting portions (22, 26) shaped in cutting edge form, i.e. having surfaces forming an acute angle with one another whereby in the vicinity of the edges facing the substrate to be coated, the said elements do not expose to the said flow any surface which is inclined downwards in the direction of the said edges.

2. Apparatus according to claim 1, characterized in that the edges (10', 16') of the diaphragms (10, 16) constituted by plates are produced in the form of a sharpened cutting edge, whose lower, substantially planar, bevelled (14, 19) face, forms an angle alpha equal to or less than 45° with respect to the upper face (15, 18).

3. Apparatus according to claim 2, characterized in that the edge (16') of the diaphragm (16) is bent upwards.

4. Apparatus according to claim 1, characterized in that the projecting cutting portions (22, 26) have a height (H) between 2 and 10 mm.

5. Apparatus according to claim 4, characterized in that the projecting cutting portions (22, 26) are fixed, in the form of separate profiled bodies, to their respective support.

6. Apparatus according to claim 5, characterized in that the separate profiled bodies are constituted by grids (25) in the form of lattices.

7. Apparatus according to claim 6, characterized in that the grids (25) are constituted by expanded metal panels.

**Patentansprüche**

1. Vorrichtung zum Vakuumbeschichten, insbesondere durch reaktive Kathodenzerstäubung, eines flächenhaften transparenten Substrats in horizontaler Lage mit einer nichtmetallischen Schicht aus einem Halbleiter, einem Metalloxid oder einer anderen Metallverbindung, mit einer evakuierbaren Beschichtungskammer, einer Trag- bzw. Transporteinrichtung für das zu beschichtende Substrat, wenigstens einer oberhalb des Substrats angeordneten das Beschichtungsmaterial tragenden Kathode und mit innerhalb der Beschichtungskammer angeordneten Elektroden und/oder Abschirmblechen und/oder Blenden, **dadurch gekennzeichnet,** daß die dem von der Kathode ausgehenden Teilchenstrom ausgesetzten Elemente oder Flächen der Elektroden (8) und/oder Blenden (10) und/oder Abschirmbleche (12) und/oder anderen Bauteile im Innern der Beschichtungskammer mit Endbereichen (10',16')und/ oder schneidenförmigen Vorsprüngen (22,26) mit einen spitzen Winkel untereinander bildenden Oberflächen versehen sind, und diese Elemente in der Nähe der dem Substrat zugewandten Endbereiche dem Teilchenstrom keine in Richtung der Endbereiche nach unten geneigte Fläche aussetzen.

2. Vorrichtung nach Anspruch 1, dadurch gekennzeichnet, daß die Endbereiche (10',16') der plattenförmigen Blenden (10,16) in Form einer spitzen Schneide ausgebildet sind, deren im wesentlichen ebene untere Schrägfläche (14,19) einen Winkel Alpha kleiner oder gleich 45 Grad zur oberen Oberfläche (15,18) bildet.

3. Vorrichtung nach Anspruch 2, dadurch gekennzeichnet, daß der Endbereich (16') der Blende (16) nach oben abgeknickt ist.

4. Vorrichtung nach Anspruch 1, dadurch gekennzeichnet, daß die schneidenartigen Vorsprünge (22,26) eine Höhe (H) von 2 bis 10 mm aufweisen.

5. Vorrichtung nach Anspruch 4, dadurch gekennzeichnet, daß die schneidenartigen Vorsprünge (22,26) als separate Profilkörper auf der jeweiligen Unterlage befestigt sind.

6. Vorrichtung nach Anspruch 5, dadurch gekennzeichnet, daß die separaten Profilkörper als rasterartige Gitter (25) ausgebildet sind.

7. Vorrichtung nach Anspruch 6, dadurch gekennzeichnet, daß die rasterartigen Gitter (25) aus Streckmetalltafeln bestehen.

EP 0 265 320 B1

**Fig. 1**

**Fig. 2**

16¹

17

18

19

16

α

**Fig. 3**

22

21

22

H

B

20

**Fig. 4**

A

25

26

26

26

26

24

A